# EUROPÄISCHE PATENTSCHRIFT

(11) **EP 1 101 282 B1**
(45) Veröffentlichungstag und Bekanntmachung des Hinweises auf die Patenterteilung: **23.01.2008**
(21) Anmeldenummer: 99942737.0
(22) Anmeldetag: 01.07.1999
(51) Int. Cl.: H03H 7/46

(54) **ANTENNENWEICHE**
ANTENNA DIPLEXER
DIPLEXEUR D'ANTENNE

(30) Priorität: 28.07.1998 DE 19833803
(43) Veröffentlichungstag der Anmeldung: 23.05.2001
(73) Patentinhaber: ROBERT BOSCH GMBH, 70442 Stuttgart (DE)
(72) Erfinder: MILITZ, Uwe, D-12161 Berlin (DE); KOEHLER, Georg, D-13587 Berlin (DE); MEIER, Thomas, D-12557 Berlin (DE)
(86) Internationale Anmeldenummer: PCT/DE1999/001919
(87) Internationale Veröffentlichungsnummer: WO 2000/007297

(56) Entgegenhaltungen:
- US-A- 4 141 016
- US-A- 5 089 829

## Beschreibung

### Stand der Technik

Die Erfindung geht von einer Schaltungsanordnung nach der Gattung des Hauptanspruchs aus.

Aus der DE 36 33 726 C2 ist bereits eine Sende- und Empfangsvorrichtung zum Empfangen von UKW-Signalen und AM-Signalen sowie zum Senden und Empfangen von Sprechfunksignalen bekannt. Die Sende- und Empfangsvorrichtung ist dabei an den Fußpunkt einer für alle drei Frequenzbereiche gemeinsamen Wendelantenne über einen gemeinsamen Anschlußpunkt angeschlossen.

Aus der US 5 089 829 ist ein AM-FM-Empfänger bekannt, bei dem ein erster Impedanzwändlungsschaltkreis für AM-Signale und ein zweiter Impedanzanpassungsschaltkreis für FM-Signale vorgesehen ist.

Aus der Druckschrift D2 (US 4 141 016) ist eine Fahrzeugantenne bekannt, die gleichzeitig über ein passives elektrisches Netzwerk mit einem 40-Kanal CB-Sende-Empfänger und über ein zweites Netzwerk mit einem AM-FM-Empfänger verbunden ist.

### Vorteile der Erfindung

Die erfindungsgemäße Schaltungsanordnung mit den Merkmalen des Hauptanspruchs hat demgegenüber den Vorteil, daß an einem ersten Anschluß der Schaltungsanordnung, der mit dem Fußpunkt der Antenne verbindbar ist, ein erster Schaltungszweig zur Auskopplung der Hochfrequenzsignale des unteren Empfangsfrequenzbereiches und ein zweiter Schaltungszweig zur Filterung der Hochfrequenzsignale des oberen Empfangsfrequenzbereiches und des Funkfrequenzbereiches vorgesehen ist. Auf diese Weise läßt sich die bei Empfang von Signalen im unteren Empfangsfrequenzbereich durch Einfluß des Empfangspfades für den oberen Empfangsfrequenzbereich und des Sende- und Empfangpfades für den Funkfrequenzbereich auftretende Schadkapazität reduzieren. Dadurch läßt sich am Ausgang des Empfangspfades für den unteren Empfangsfrequenzbereich eine höhere Signalleistung erzielen.

Durch die in den Unteransprüchen aufgeführten Maßnahmen sind vorteilhafte Weiterbildungen und Verbesserungen der im Hauptanspruch angegebenen Schaltungsanordnung möglich.

### Zeichnung

Ein Ausführungsbeispiel der Erfindung ist in der Zeichnung dargestellt und in der nachfolgenden Beschreibung näher erläutert. Es zeigen Figur 1 eine erfindungsgemäße Schaltungsanordnung, Figur 2 einen Frequenzplan für die Aufteilung des Frequenzbandes in die Empfangsfrequenzbereiche und den Funkfrequenzbereich und Figur 3 ein Ersatzschaltbild, das die Wirkung der Antenne und der erfindungsgemäßen Schaltungsanordnung auf dem Empfangspfad für den unteren Empfangsfrequenzbereich beschreibt.

### Beschreibung des Ausführungsbeipsiels

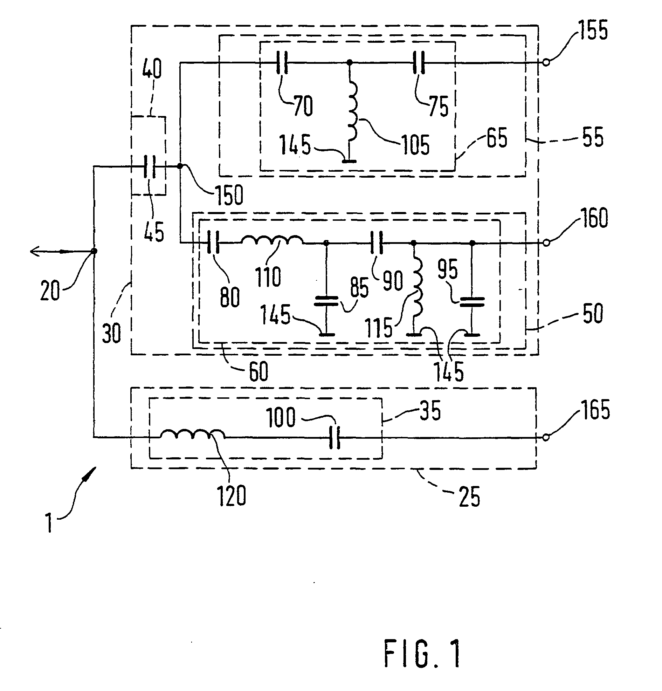

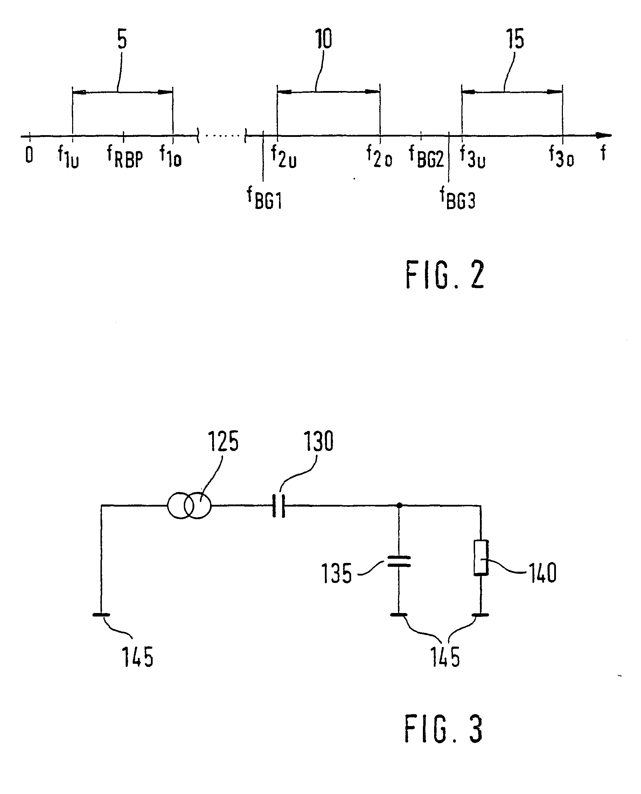

In Figur 1 kennzeichnet 1 eine Schaltungsanordnung, die als Antennenweiche ausgebildet ist. Einem ersten Anschluß 20 der Schaltungsanordnung 1 werden Hochfrequenzsignale eines unteren Empfangsfrequenzbereiches 5, eines oberen Empfangsfrequenzbereiches 10 und eines Funkfrequenzbereiches 15 von einer gemeinsamen Antennenanordnung, z.B. einer Stabantenne zugeführt. Vom ersten Anschluß 20 können auch Hochfrequenzsignale des Funkfrequenzbereiches 15 an die Antennenanordnung zur Abstrahlung abgegeben werden. Beim unteren Empfangsfrequenzbereich 5 kann es sich beispielsweise um einen AM- oder LMK-Rundfunkfrequenzbereich handeln. Beim oberen Empfangsfrequenzbereich 10 kann es sich beispielsweise um einen FM- oder UKW-Rundfunkfrequenzbereich handeln. Beim Funkfrequenzbereich 15 kann es sich beispielsweise um einen GSM-Funkfrequenzbereich (Global System for Mobile Communications) handeln. Figur 2 zeigt beispielhaft eine Anordnung der drei Frequenzbereiche 5, 10, 15 in Abhängigkeit der Frequenz f. Der untere Empfangsfrequenzbereich 5 reicht dabei von einer ersten unteren Grenzfrequenz fₗᵤ bis zu einer ersten oberen Grenzfrequenz fₗₒ. Der obere Empfangsfrequenzbereich 10 reicht von einer zweiten unteren Grenzfrequenz f₂ᵤ bis zu einer zweiten oberen Grenzfrequenz f₂ₒ. Der Funkfrequenzbereich 15 reicht von einer dritten unteren Grenzfrequenz f₃ᵤ bis zu einer dritten oberen Grenzfrequenz f₃ₒ. Die drei Frequenzbereiche 5, 10, 15 sollen dabei nicht überlappen, so daß gilt: f₁ᵤ < f₁ₒ < f₂ᵤ < f₂ₒ < f₃ᵤ < f₃ₒ.

Der erste Anschluß 20 ist über einen ersten Hochpass 40 mit einem zweiten Anschluß 150 verbunden. Der zweite Anschluß 150 ist über einen zweiten Hochpass 65 mit einem dritten Anschluß 155 verbunden. An den dritten Anschluß 155 kann dabei eine Funksende- und -empfangseinheit angeschlossen sein. Der zweite Anschluß 150 ist außerdem über einen Tiefpass 60 mit einem vierten Anschluß 160 verbunden. Der vierte Anschluß 160 kann dabei an den FM-Empfangsteil eines Autoradios angeschlossen sein. Der erste Anschluß 20 ist über einen Bandpass 35 mit einem fünften Anschluß 165 verbunden. Der fünfte Anschluß 165 kann unter Zwischenschaltung eines Verstärkers zur aktiven Impedanzanpassung mit einem AM-Empfangsteil des Autoradios verbunden sein. Der Bandpass 35 bildet einen ersten Schaltungszweig 25 zur Auskopplung der Hochfrequenzsignale des unteren Empfangsfrequenzbereiches 5. Die Resonanzfrequenz f_{RBP} des Bandpasses 35 liegt dabei möglichst mittig im unteren Empfangsfrequenzbereich 5 gemäß Figur 2.

Der erste Hochpass 40, der zweite Hochpass 65 und der Tiefpass 60 bilden einen zweiten Schaltungszweig 30 zur Filterung der Hochfrequenzsignale des oberen Empfangsfrequenzbereiches 10 und des Funkfrequenzbereiches 15. Die untere Bandgrenze f_{BG1} des ersten Hochpasses 40 liegt dabei oberhalb des unteren Empfangsfrequenzbereiches 5 und unterhalb des oberen Empfangsfrequenzbereiches 10, so daß durch den ersten Hochpass 40 sowohl die Hochfrequenzsignale des oberen Empfangsfrequenzbereiches 10 als auch die Hochfrequenzsignale des Funkfrequenzbereiches 15 durchgelassen werden, wohingegen die Hochfrequenzsignale des unteren Empfangsfrequenzbereiches 5 durch den ersten Hochpass 40 unterdrückt werden. Der Tiefpass 60 bildet einen ersten Unterschaltungszweig 50 des zweiten Schaltungszweiges 30 zur Auskopplung der Hochfrequenzsignale des oberen Empfangsfrequenzbereiches 10 und zur Unterdrückung der Hochfrequenzsignale des Funkfrequenzbereiches 15. Dazu liegt die obere Bandgrenze f_{BG2} des Tiefpasses 60 unterhalb des Funkfrequenzbereiches 15 und oberhalb des oberen Empfangsfrequenzbereiches 10. Der zweite Hochpass 65 bildet einen zweiten Unterschaltungszweig 55 des zweiten Schaltungszweiges 30 zur Auskopplung der Hochfrequenzsignale des Funkfrequenzbereiches 15 und zur Unterdrückung der Hochfrequenzsignale des oberen Empfangsfrequenzbereiches 10. Dabei liegt die untere Bandgrenze f_{BG3} des zweiten Hochpasses 65 oberhalb des oberen Empfangsfrequenzbereiches 10 und unterhalb des Funkfrequenzbereiches 15, so daß für die Grenzfrequenzen der Frequenzbereiche 5, 10, 15 und die beschriebenen Bandgrenzen der Filter 35, 40, 60, 65 folgender Zusammenhang gilt:
fₗᵤ < f_{RBP} < f₁ₒ < f_{BG1} < f₂ᵤ < f₂ₒ < f_{BG2} < f_{BG3} < f₃ᵤ < f₃ₒ.

Gemäß Figur 1 ist der Bandpass 35 aus einer Serienschaltung einer vierten Spule 120 und eines achten Kondensators 100 gebildet. Der erste Hochpass 40 ist durch einen ersten Kondensator 45 gebildet. Der Tiefpass 60 ist gebildet durch eine Parallelschaltung eines siebten Kondensators 95 und einer dritten Spule 115, die einerseits mit dem vierten Anschluß 160 und andererseits mit einem Bezugspotential 145 verbunden ist. Ein sechster Kondensator 90 des Tiefpasses 60 ist einerseits ebenfalls mit dem vierten Anschluß 160 und andererseits über einen fünften Kondensator 85 des Tiefpasses 60 mit dem Bezugspotential 145 und über eine Serienschaltung aus einem vierten Kondensator 80 des Tiefpasses 60 und einer zweiten Spule 110 des Tiefpasses 60 mit dem zweiten Anschluß 150 verbunden. Der zweite Hochpass 65 umfaßt einen dritten Kondensator 75, der einerseits mit dem dritten Anschluß 155 und andererseits über eine erste Spule 105 des zweiten Hochpasses 65 mit dem Bezugspotential 145 und über einen zweiten Kondensator 70 des zweiten Hochpasses 65 mit dem zweiten Anschluß 150 verbunden ist.

Der erste Anschluß 20 bildet einen für alle drei Frequenzbereiche 5, 10, 15 gemeinsamen Anschluß, der mit einem Fußpunkt der in Figur 1 nicht dargestellten Antennenanordnung verbindbar ist. Diese Antennenanordnung ist somit für alle drei Frequenzbereiche 5, 10, 15 eine gemeinsame Antenne. Ist die Antenne als Stabantenne ausgebildet, so kann ihre Länge im Bereich einer viertel Wellenlänge der Wellenlängen des oberen Empfangsfrequenzbereiches 10 und des Funkfrequenzbereiches 15 gewählt werden, da der obere Empfangsfrequenzbereich 10 und der Funkfrequenzbereich 15 im Vergleich zum unteren Empfangsfrequenzbereich 5 gemäß Figur 2 vergleichsweise nahe beieinanderliegen, was durch die unterbrochene und an der Unterbrechungsstelle gepunktete Frequenzachse in Figur 2 zu erkennen ist. Dies gilt besonders bei Ausbildung des Funkfrequenzbereiches 15 als GSM-Funkfrequenzbereich, des oberen Empfangsfrequenzbereiches 10 als FM-Rundfunkfrequenzbereiches und des unteren Empfangsfrequenzbereiches 5 als AM-Rundfunkfrequenzbereich. Die Stabantenne ist somit aufgrund ihrer Länge nicht auf den unteren Empfangsfrequenzbereich 5 abgestimmt, der vergleichsweise große Wellenlänge beinhaltet und damit eine viel längere Antenne erforderte. Daraus resultiert im allgemeinen die Notwendigkeit, an den fünften Anschluß 165 einen Verstärker zur aktiven Impedanzanpassung des ersten Schaltungszweiges 25 für den Empfang von Hochfrequenzsignalen im unteren Empfangsfrequenzbereich 5 anzuschließen.

In Figur 3 ist ein Ersatzschaltbild dargestellt, das die Wirkung der nicht auf den unteren Empfangsfrequenzbereich 5 abgestimmten Antennenanordnung sowie der Schaltungsanordnung 1 beim Empfang von Hochfrequenzsignalen im unteren Empfangsfrequenzbereich 5 auf eine im fünften Anschluß 165 anzuschließende Nutzlast in Form einer ohmschen Lastimpedanz 140 beschreibt. Das empfangene Antennensignal ist als Spannungsquelle 125 dargestellt und einerseits mit dem Bezugspotential 145 und andererseits mit einer Antennenkapazität 130 verbunden, die den Einfluß der Nichtanpassung der Antennenanordnung an den ersten Schaltungszweig 25 beschreibt. Die einerseits mit der Spannungsquelle 125 verbundene Antennenkapazität 130 ist andererseits über eine Parallelschaltung aus einer Schadkapazität 135 und der Lastimpedanz 140 mit dem Bezugspotential 145 verbunden. Die Schadkapazität 135 stellt dabei die bei Empfang von Hochfrequenzsignalen im unteren Empfangsfrequenzbereich 5 auftretenden kapazitiven Verluste im zweiten Schaltungszweig 30 dar. Diese sind im wesentlichen bestimmt durch die Kapazität des ersten Kondensators 45, die jedoch durch die nachgeschalteten Kondensatoren im ersten Unterschaltungszweig 50 und im zweiten Unterschaltungszweig 55 abgeschwächt wird.

Auf diese Weise läßt sich die Schadkapazität 135 begrenzen und eine entsprechende Signalleistung am fünften Anschluß 165 erzielen, die gegebenenfalls den Einsatz einer aktiven Impedanzanpassung mittels eines an den fünften Anschluß 165 anzuschließenden Verstärkers überflüssig macht.

Die vom zweiten Schaltungszweig 30 herrührenden kapazitiven Verluste, sind durch die Schadkapazität 135 dargestellt. Die nicht auf den unteren Empfangsfrequenzbereich 5 abgestimmte Antennenanordnung hat im unteren Empfangsfrequenzbereich 5 die Antennenkapazität 130. Die im zweiten Schaltungszweig 30 auftretenden Kapazitäten, die durch die Schadkapazität 135 dargestellt sind, stellen zusammen mit der Antennenkapazität 130 einen kapazitiven Spannungsteiler dar. Je kleiner die Schadkapazität 135, desto größer ist die Spannung an der Lastimpedanz 140 und somit das Nutzsignal. Anders ausgedrückt gilt, je kleiner die Schadkapazität 135, desto kleiner sind die kapazitiven Verluste, die durch den zweiten Schaltungszweig 30 verursacht werden. Durch die beschriebene Wahl der Länge der als Stabantenne ausgebildeten Antennenanordnung ergibt sich für empfangene Hochfrequenzsignale im oberen Empfangsfrequenzbereich 10 und im Funkfrequenzbereich 15 im wesentlichen eine Anpassung des zweiten Schaltungszweiges 30 an die im oberen Empfangsfrequenzbereich 10 und im Funkfrequenzbereich 15 im wesentlichen reelle Fußpunktimpedanz der Antennenanordnung. Daher ergeben sich dann im zweiten Schaltungszweig 30 bei Empfang von Hochfrequenzsignalen im oberen Empfangsfrequenzbereich 10 und im Funkfrequenzbereich 15 im wesentlichen keine kapazitiven Verluste, so daß keine aktive Impedanzanpassung am dritten Anschluß 155 und am vierten Anschluß 160 erforderlich ist.

Die erfindungsgemäße Schaltungsanordnung 1 läßt sich beispielsweise als Antennenweiche in Kraftfahrzeugen in Verbindung mit-entsprechenden Kombiantennen für die drei Frequenzbereiche 5, 10, 15 einsetzen, ist jedoch nicht auf diesen Anwendungsfall beschränkt und kann beispielsweise auch in Flugzeugen oder anderen Fahrzeugen oder auch stationär eingesetzt werden.

## Patentansprüche

1. Schaltungsanordnung (1) zum Empfangen von Hochfrequenzsignalen eines unteren Empfangsfrequenzbereiches (5) und eines oberen Empfangsfrequenzbereiches (10), insbesondere eines AM/LMK-Rundfunkfrequenzbereiches und eines FM/UKW-Rundfunkfrequenzbereiches, und zum Empfangen und Senden von Hochfrequenzsignalen eines Funkfrequenzbereiches (15), insbesondere eines GSM-Funkfrequenzbereichs, zum Anschluß an eine für alle drei Frequenzbereiche (5, 10, 15) gemeinsame Antenne, die nicht auf den unteren Empfangsfrequenzbereich (5) abgestimmt ist, wobei ein erster Anschluß (20) der Schaltungsanordnung (1) mit einem Fußpunkt der Antenne verbindbar ist, **dadurch gekennzeichnet, daß** am ersten Anschluß (20) ein erster Schaltungszweig (25) zur Auskopplung der Hochfrequenzsignale des unteren Empfangsfrequenzbereiches (5) und ein zweiter Schaltungszweig (30) zur Auskopplung der Hochfrequenzsignale des oberen Empfangsfrequenzbereiches (10) und des Funkfrequenzbereiches (15) vorgesehen ist.

2. Schaltungsanordnung (1) nach Anspruch 1, **dadurch gekennzeichnet, daß** der erste Schaltungszweig (25) einen Bandpaß (35) umfaßt, dessen Resonanzfrequenz f_{RBP} im unteren Empfangsfrequenzbereich (5) liegt.

3. Schaltungsanordnung (1) nach Anspruch 1 oder 2, **dadurch gekennzeichnet, daß** der zweite Schaltungszweig (30) einen Hochpaß (40) umfaßt, dessen untere Bandgrenze f_{BG1} oberhalb des unteren Empfangsfrequenzbereichs (5) liegt.

4. Schaltungsanordnung (1) nach Anspruch 3, **dadurch gekennzeichnet, daß** der Hochpaß (40) einen Kondensator (45) umfaßt.

5. Schaltungsanordnung (1) nach einem der vorherigen Ansprüche, **dadurch gekennzeichnet, daß** der zweiten Schaltungszweig (30) einen ersten Unterschaltungszweig (50) zur Filterung der Hochfrequenzsignale des oberen Empfangsfrequenzbereiches (10) und einen zweiten Unterschaltungszweig (55) zur Filterung der Hochfrequenzsignale des Funkfrequenzbereiches (15) umfaßt.

6. Schaltungsanordnung (1) nach Anspruch 5, **dadurch gekennzeichnet, daß** der erste Unterschaltungszweig (50) einen Tiefpaß (60) aufweist, dessen obere Bandgrenze f_{BG2} unterhalb des Funkfrequenzbereichs (15) liegt und daß der zweite Unterschaltungszweig (55) einen Hochpaß (65) aufweist, dessen untere Bandgrenze f_{BG3} oberhalb des oberen Empfangsfrequenzbereichs (10) liegt.

## Claims

1. Circuit arrangement (1) for receiving radio-frequency signals in a lower reception frequency range (5) and in an upper reception frequency range (10), particularly in an AM/LW/MW/SW broadcast radio frequency range and an FM/UHF broadcast radio frequency range, and for receiving and sending radio-frequency signals in a radio frequency range (15), particularly a GSM radio frequency range, for connection to an antenna which is common to all three frequency ranges (5, 10, 15) and which is not tuned to the lower reception frequency range (5), a first connection (20) of the circuit arrangement (1) being able to be connected to a base of the antenna, **characterized in that** the first connection (20) has a first circuit path (25) provided on it for decoupling the radio-frequency signals from the lower reception frequency range (5) and has a second circuit path (30) provided on it for decoupling the radio-frequency signals from the upper reception frequency range (10) and from the radio frequency range (15).

2. Circuit arrangement (1) according to Claim 1, **characterized in that** the first circuit path (25) comprises a bandpass filter (35) whose resonant frequency f_{RBP} is in the lower reception frequency range (5).

3. Circuit arrangement (1) according to Claim 1 or 2, **characterized in that** the second circuit path (30) comprises a high-pass filter (40) whose lower band limit f_{BG1} is above the lower reception frequency range (5).

4. Circuit arrangement (1) according to Claim 3, **characterized in that** the high-pass filter (40) comprises a capacitor (45).

5. Circuit arrangement (1) according to one of the preceding claims, **characterized in that** the second circuit path (30) comprises a first subcircuit path (50) for filtering the radio-frequency signals from the upper reception frequency range (10) and a second subcircuit path (55) for filtering the radio-frequency signals from the radio frequency range (15).

6. Circuit arrangement (1) according to Claim 5, **characterized in that** the first subcircuit path (50) has a low-pass filter (60) whose upper band limit f_{BG2} is below the radio frequency range (15), and **in that** the second subcircuit path (55) has a high-pass filter (65) whose lower band limit f_{BG3} is above the upper reception frequency range (10).

## Revendications

1. Circuit (1) pour recevoir des signaux haute fréquence d'une plage de réception de fréquences inférieures (5) et une plage de réception de fréquences supérieures (10), notamment d'une plage de fréquence radio AM/LMK et d'une plage de fréquence radio MF/VHF, et pour recevoir et émettre des signaux hautes fréquences, d'une plage de fréquence radio (15), notamment d'une plage de fréquence radio GMS, pour se brancher sur une antenne commune aux trois plages de fréquences (5, 10, 15) qui ne soit pas accordée sur la plage de réception de fréquences inférieures (5),
un premier branchement (20) du circuit (1) étant relié au pied de l'antenne,
**caractérisé en ce que**
le premier branchement (20) comporte une première branche de circuit (25) pour découpler les signaux haute fréquence de la plage de réception de fréquences inférieures (5) et une seconde branche de circuit (30) est prévue pour découpler les signaux haute fréquence de la plage de réception de fréquences supérieures (10) et de la plage de fréquence radio (15).

2. Circuit (1) selon la revendication 1,
**caractérisé en ce que**
la première branche (25) comprend un filtre passe-bande (35) dont la fréquence de résonance (f_{RBP}) se situe dans la plage de réception de fréquences inférieures (5).

3. Circuit (1) selon la revendication 1 ou 2,
**caractérisé en ce que**
la seconde branche de circuit (30) comprend un filtre passe-haut (40) dont la limite inférieure de bande (F_{BG1}) se situe au-dessus de la plage de réception de fréquences inférieures (5).

4. Circuit (1) selon la revendication 3,
**caractérisé en ce que**
le filtre passe-haut (40) comporte un condensateur (45).

5. Circuit (1) selon l'une des revendications précédentes,
**caractérisé en ce que**
la seconde branche de circuit (30) comporte une première branche de division (50) pour filtrer les signaux de haute fréquence de la première plage de réception de fréquences supérieures (10) et une seconde branche de division (55) pour filtrer les signaux haute fréquence de la plage des fréquences radio (15).

6. Circuit (1) selon la revendication 5,
**caractérisé en ce que**
la première branche de division (50) comporte un filtre passe-bas (60) dont la limite de bande supérieure (f_{BG2}) se situe en dessous de la plage de fréquences radio (15) et la seconde branche de division (55) comporte un filtre passe-haut (65) dont la limite de bande inférieure (f_{BG3}) se situe au-dessus de la plage de réception des fréquences supérieures (10).
